# EUROPEAN PATENT SPECIFICATION

(11) **EP 0 522 670 B1**
(45) Date of publication and mention of the grant of the patent: **26.03.1997**
(21) Application number: 92203132.3
(22) Date of filing: 24.11.1986
(51) Int. Cl.: H01L 29/739

(54) **Fast switching lateral insulated gate field effect transistor**
Schnellschaltender, lateraler Feldeffekttransistor mit isolierter Steuerelektrode
Transistor latéral à effet de champ, à grille isolée, et commutant rapidement

(30) Priority: 27.11.1985 US 802781
(43) Date of publication of application: 13.01.1993
(62) Divisional of application: 86202083.1
(73) Proprietor: Philips Electronics N.V., 5621 BA Eindhoven (NL)
(72) Inventor: Colak, Sel, c/o Internationaal Octrooibureau B.V., NL-5656 AA Eindhoven (NL); Rumennik, Vladimir, c/o Internationaal, NL-5656 AA Eindhoven (NL)
(74) Representative: Houbiers, Ernest Emile Marie Gerlach

(56) References cited:
- EP-A- 0 111 803
- EP-A- 0 115 098
- EP-A- 0 201 945
- DE-A- 2 706 031
- US-A- 4 300 150
- TECHNICAL DIGEST OF THE INTERNATONAL ELECTRON DEVICES MEETING 1985 December 1985, WASHINGTON, DC USA pages 740 - 743 M. R. SIMPSON ET AL. 'Analysis of the Lateral Insulated Gate Transistor'

## Description

### BACKGROUND OF THE INVENTION

The invention relates to a lateral insulated gate field effect transistor as set out in the preamble of claim 1.

Such a device is described in European Patent Application No.111803.

MOS devices are generally well-known in the art, and a typical prior art high-voltage lateral DMOS transistor is shown in Fig. 1 of U.S. Patent No. 4,300,150. This device includes a semiconductor substrate of a first conductivity type (p-type), an epitaxial surface layer of a second conductivity type (n-type) on a major surface of the substrate, a surface-adjoining channel region of the first conductivity type in the epitaxial layer, a surface-adjoining source region of the second conductivity type in the channel region, and a surface-adjoining drain region of the second conductivity type in the epitaxial layer and spaced apart from the channel region. An insulating layer is provided on the epitaxial surface layer and covers at least that portion of the channel region located between the source and drain. A gate electrode is provided on the insulating layer, over the portion of the channel region located between the source and drain and is electrically isolated from the epitaxial surface layer by the insulating layer (referred to as the gate oxide), while source and drain electrodes are connected respectively to the source and drain regions of the transistor. Such prior art high-voltage DMOS transistors typically have a relatively thick epitaxial layer, in the order of about 25-30 micrometres for a breakdown voltage of about 250 V.

It has been found that the breakdown characteristics of high-voltage semiconductor devices can be improved by using the REduced SURface Field (or RESURF) technique, as described in "High Voltage Thin Layer Devices (RESURF Devices)", "International Electronic Device Meeting Technical Digest", December 1979, pages 238-240, by Appels et al, and U.S. Patent No. 4,292,642, incorporated thereby by reference. Essentially, the improved breakdown characteristics of RESURF devices are achieved by employing thinner but more highly doped epitaxial layers to reduce surface fields. Additionally, surface and buried regions having no direct external connections have been used to redistribute surface fields in MOS devices, as shown, for example, in U.S. Patent No. 4,300,150 and Japanese Kokai No. 45074-81.

The RESURF technique was applied to lateral double-diffused MOS transistors, as reported in "Lateral DMOS Power Transistor Design", "IEEE Electron Device Letters", Vol.EDL-1, pages 51-53, April 1980, by Colak et al, and the result was a substantial improvement in device characteristics. In high-voltage DMOS devices, there is normally a trade-off between breakdown voltage and "on" resistance, with the goal being to increase the breakdown voltage level while maintaining a relatively low "on" resistance. Using the RESURF technique, and for reference assuming a constant breakdown voltage, an improvement (e.g. decrease) in "on" resistance by a factor of about 3 may be obtained in a device occupying the same area as a conventional (thick epitaxial layer) DMOS device. Nevertheless, a further improvement in the "on" resistance characteristics of such devices would be extremely desirable, particularly for high-voltage power devices where "on" resistance is an important parameter. Ideally, such an improvement should be obtained without significantly degrading breakdown voltage or switching characteristics.

In seeking to create more efficient power switching devices, a new type of device, the Lateral Insulated Gate Transistor (hereinafter LIGT) also called Lateral Insulated Gate Rectifier or LIGT, was recently developed. The LIGT essentially modifies the LDMOS structure of the general type described above with an anode region implanted near the drain region. In the LIGT, during the "on" state, current is conducted by the electron-hole plasma. The electrons are injected from the accumulation region under the gate and the holes are injected from the anode, resulting in conductivity modulation of the drift region. The current is dominated by the recombination mechanism in a manner similar to a p-i-n diode. As current increases, some of the holes injected by anode flow through the substrate, forward biasing the episubstrate junction. The substrate becomes partially conductivity-modulated and also contributes to the recombination current. At a high current level, holes injected from the anode may flow through the channel resistance, forward biasing the double-diffused junction, and thus resulting in latch-up.

In the LIGT, the addition of the anode region changes the mechanism of the current conduction in the device's drift region. In the "on" state the current is initially conducted by the majority carriers, as in LDMOS transistors. Electrons flow from the source through the gated inversion region, through the drift region (which is the largest contributor towards the "on" resistance), and then into the drain. When drain current reaches a level high enough to forward bias the drain junction, the drain starts injecting holes into the drift region, forming a neutral plasma. The density of these injected minority carriers is higher than the doping level of the impurities in the drift region. The injected carriers modulate the resistance of the drift region, thus reducing overall "on" resistance. The injected minority carriers can flow both into the substrate and onto the channel region.

### SUMMARY OF THE INVENTION

It is therefore an object of the present invention to provide a lateral insulated gate transistor device which has high current handling capabilities, low "on" resistance and high breakdown voltage, and which is process-compatible with bipolar and MOS control circuits.

Accordingly, the lateral insulated gate field effect transistor of the present invention is characterized in that it has a second buried layer of the second conductivity type located at the first major surface of the substrate and beneath the anode region and the drain region, as set out in the characterising part of claim 1.

By providing an anode region side by side and in direct contact with said drain region, and by appropriately contacting both the anode and drain regions with a common anode-drain electrode, a LIGT device is obtained which exhibits fast switching characteristics.

### BRIEF DESCRIPTION OF THE DRAWING

Fig. 1 is a cross-sectional view of a semiconductor device with a lateral insulated gate transistor in accordance with a first embodiment of the invention; and
Fig. 2 is a cross-sectional view of a LIGT device in accordance with a second embodiment of the invention.

### DESCRIPTION OF THE PREFERRED EMBODIMENTS

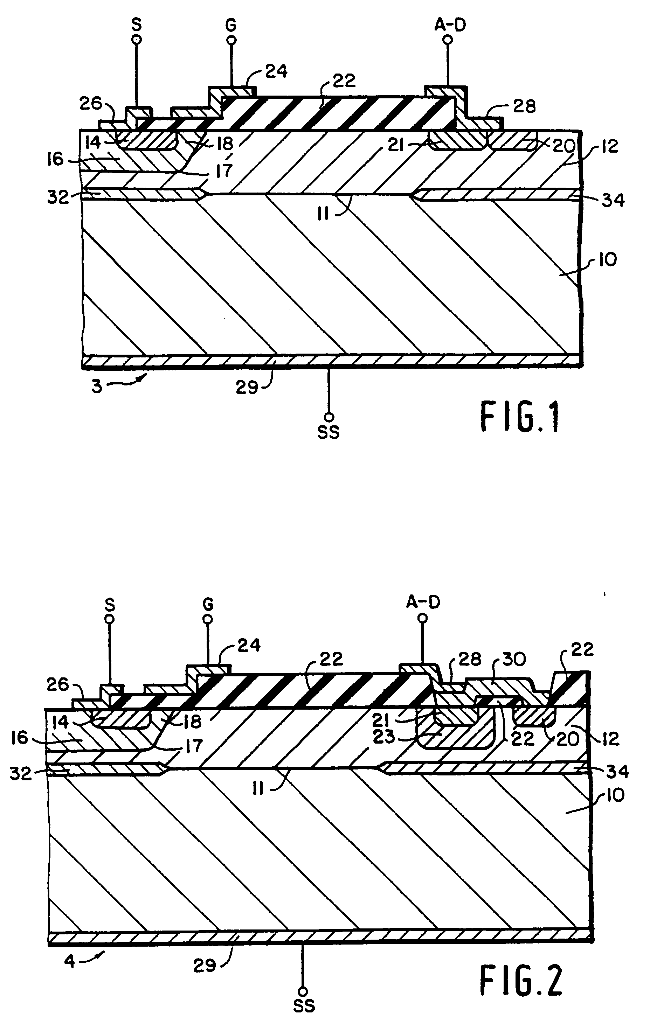

Figure 1 of the drawing shows a fast switching lateral insulated gate transistor suitable for high-voltage applications. It should be noted that the Figures are not drawn to scale, and in particular the vertical dimensions are exaggerated for improved clarity. Additionally, semiconductor regions of the same conductivity type are generally shown hatched in the same direction.

In Figure 1, a lateral device 3 has a semiconductor substrate 10 of a first conductivity type, here p-type, with an epitaxial surface layer 12 of a second conductivity type opposite to that of the first, here n-type, on a first major surface 11 of the substrate. A surface-adjoining channel region 16 of the first conductivity type is provided in the epitaxial layer and forms a p-n junction 17 therewith. A surface-adjoining source region 14 of the second conductivity type is provided in the channel region 16, and a surface-adjoining drain region 20, also of the second conductivity type, is provided in the epitaxial layer 12 at a location which is spaced apart from the channel region 16. The channel region 16 has a surface-adjacent portion 18 located between the source and drain regions which forms the channel of the device. An insulating layer 22 is provided on the epitaxial surface layer 12 and covers at least that portion of the channel region 16 located between the source and drain regions of the transistor. While insulating layer 22 is shown as a stepped layer and is of silicon oxide, other configurations and insulating materials can be used without departing from the scope of the invention. A gate electrode 24 (terminal G) is provided on the insulating layer 22 over the channel 18, and source (26) and drain (28) electrodes (terminals S and D, respectively) provide electrical connections to the source and drain regions of the transistor. A substrate electrode 29 (terminal SS) provides an electrical connection to the second major surface 13 of the substrate on its lower side. Devices of this general type (as so far described) are well known in the art, and hence will not be described in further detail.

The Reduced Surface Field (RESURF) techniques, as described in the previously-mentioned Colak et al paper, can be used to improve "on" resistance and/or breakdown voltage in devices of this type. By substantially reducing the epitaxial layer thickness, down to about 3 to 15 micrometres, while at the same time increasing the doping level in the epitaxial layer to maintain an acceptable "on" resistance value, a substantial improvement in high-voltage breakdown characteristics can be obtained. Thus, the device as so far described, may also be a RESURF MOS device, assuming that the appropriate thickness and resistivity values for the epitaxial layer 12 are selected. In accordance with the RESURF technique, the product of doping concentration and epitaxial layer thickness (Nₑₚᵢ x dₑₚᵢ) should typically be approximately 2x10¹² atoms /cm². Using this technique, "on" resistance can be reduced by a factor of about 3 for a device occupying the same area as a conventional device, while maintaining the same breakdown voltage.

As described in the Jayaraman, Rumennik et al publication mentioned above, the basic lateral insulated gate transistor structure is obtained by modifying the MOS structure of the type previously described by adding an anode region of the first conductivity type within the drain region. A typical prior-art LIGT device of this type is shown in Fig. 1 (b) of the Jayaraman, Rumennik et al article. As previously noted, while LIGT devices of this type offer several important advantages, they suffer from the important drawback of a relatively long (3-10 microsecond) turn-off time. In order to overcome this drawback, the device shown in Fig. 1 additionally includes a surface-adjoining anode region 21 of the first conductivity type, here p-type, in the epitaxial layer and adjacent and in contact with the drain region 20. Said surface-adjoining anode region (21) and drain region (20) are side by side and in direct contact with each other. The device is further modified by having an electrode 28 which directly contacts both the anode region 21 and the drain region 20, thus becoming a common anode-drain (A-D) electrode in this embodiment.

In this structure of Fig. 1, the anode region 21 by way, of example, is a highly-doped p-type region having a doping concentration of about 10²⁰ atoms/cm³ and a thickness of about 1 micrometre. Other portions of the device structure are configured and doped in accordance with conventional techniques for fabricating lateral MOS and RESURF transistors, such as those shown in Colak U.S. Patent No. 4,300,150, incorporated herein by reference.

The device is additionally provided with a first buried layer 32 of p-type conductivity and a doping level of about 5 x 10¹⁶ atoms/cm³ located at the first major surface 11 of the substrate 10 and beneath the source and channel regions. In accordance with the invention, a second buried layer 34 of n-type conductivity and a doping level of about 10¹⁷ atoms/cm³ is also provided at first major surface 11 and beneath anode region 21 and drain region 20. The thickness of buried layers 32 and 34 may be between about 1-5 micrometres.

Such buried layers are also incorporated in a device according to a second embodiment of the invention, shown in Fig. 2 in which the p-type anode region 21 of device 4 is provided in a surface-adjoining region 23 of n-type conductivity with a doping concentration of about 10¹⁷ - 10¹⁸ atoms/cm³ and a thickness of about 1.5 micrometre. Drain region 20, of n-type material, is then provided adjacent but not in direct contact with the anode region.

In this second embodiment, the drain region 20 is coupled to anode region 21 by means of a resistive element 30, which may be of polysilicon or other suitable resistive material. A portion of insulating layer 22 is provided beneath resistive element 30, as shown in Fig. 2, in order to prevent electrical contact between the resistive element and either highly-doped surface-adjoining region 23, or epitaxial surface layer 12. The construction of the device shown in Fig. 2, insofar as it differs from the previously-described device of Fig. 1, is completed by the provision of anode-drain electrode 28 on resistive element 30. A portion of anode-drain electrode 28 is provided directly above anode region 21, so that the anode-drain electrode is connected substantially directly to the anode region through the thickness of resistor element 30 (shown much magnified in Fig. 2) or directly through a window in the resistive material. Additionally, the anode-drain electrode is resistively coupled to the drain region 20 by the series resistance of resistive element 30 along substantially its entire length, which can be appropriately selected to achieve the desired resistance.

Lateral gate transistors in accordance with the invention, as described above, may be fabricated starting with a p-type substrate having a doping level of about 5.0 x 10¹⁴ atoms/cm³ on which is grown an n-type epitaxial layer having a thickness of about 7 micrometres and a doping level about 3.0 x 10¹⁵ atoms/cm³. The source, channel, anode, drain and the surface adjoining region (present in the embodiment shown in Fig. 2) are then provided by conventional implantation and diffusion techniques. The doping level of the n-type regions may typically be about 10²⁰ atoms/cm³ and the doping level of the p-type regions may be about 10¹⁸ atoms/cm³. The device construction is then completed by the provision, in a conventional matter, of the insulating layer 22, of silicon oxide or an equivalent dielectric, the resistive element 30 of polysilicon or the like (present in the embodiment shown in Fig. 2), and the source, gate, substrate and anode-drain electrodes.

In terms of operation, the LIGT devices of the present invention are connected and operated in substantially the same manner as prior art LDMOST devices. General operating characteristics of the LIGT are described in some detail in the previously-mentioned Jayaraman, Rumennik et al publication.

The high-voltage breakdown characteristics of the device shown in Figs. 1 and 2 are improved by the incorporation of the previously-described buried layers 32 and 34, in accordance with the invention. The p-type buried layer 32 serves to enhance breakdown voltage characteristics, while the n-type buried layer 34 serves to prevent punch-through.

In order to obtain additional flexibility in device design, the embodiment shown in fig. 2, using resistive element 30 to couple drain region 20 to anode region 21 and anode-drain electrode 28, may be employed. In this embodiment, at low current levels, the source current for the most part flows into the drain region 20, then through the resistance of resistive region 30 (typically about 1-5 ohms) and then into the anode-drain electrode 28. As the current increases, due to an increase in the gate voltage, the anode region 21 supplies sufficient carriers to modulate the conductivity of the epitaxial layer, and most of the current flows into the anode region and then substantially directly to the anode-drain electrode 28. The ratio of currents flowing into the drain electrode 28 form the drain and anode regions can be controlled by selecting the resistance value of resistive element 30, as well as the distance between the anode and drain regions and the epitaxial layer resistivity. As in the previously-described embodiment, turn-off times are substantially improved by providing a path for removing minority carriers through the drain region.

While the invention has been particularly shown and described with reference to several preferred embodiments thereof, it will be understood by those skilled in the art that various changes in form and detail may be made without departing from the scope of the invention as defined by the appended claims.

## Claims

1. A lateral insulated gate field effect transistor (3,4) having a semiconductor substrate (1a) of a first conductivity type having a major surface (11), an epitaxial surface layer (12) of a second conductivity type opposite to that of the first on said major surface of said substrate, a surface adjoining channel region (16) of said first conductivity type in said epitaxial layer and forming a pn-junction (17) therewith, a surface adjoining source region (14) of said second conductivity type in said channel region, a surface adjoining drain region (20) of said second conductivity type in said epitaxial layer and spaced apart from said channel region by a portion of said epitaxial layer, an insulating layer (22) on said epitaxial layer and covering at least that portion (18) of said channel region located between said source region and said drain region, a gate electrode (24) on said insulating layer, over said portion of the channel region and electrically isolated from said epitaxial layer, a surface adjoining anode region (21) of said first conductivity type situated in said epitaxial layer adjacent said drain region and electrically coupled to said drain region, an electrode (28) electrically connected to said anode region, a source electrode (26) electrically connected to said source region, a substrate electrode (29) contacting said substrate, and a first buried layer (32) of said first conductivity type located at said major surface of said substrate and beneath said source region and said channel region, characterized in that a second buried layer (34) of said second conductivity type is located at said major surface of said substrate and beneath said anode region and said drain region.

2. A semiconductor device as claimed in claim 1, characterized in that the anode region (21) is provided side by side and in direct contact with said drain region (20) and in that said electrode (28) electrically connected to said anode region directly contacts both said drain region and said anode region.

## Patentansprüche

1. Lateraler Feldeffekttransistor mit isoliertem Gate (3, 4) mit einem Halbleitersubstrat (la) eines ersten Leitungstyps mit einer Hauptfläche (11), einer epitaktischen Oberflächenschicht (12) eines zweiten, dem ersten Leitungstyp entgegengesetzten Leitungstyps auf der genannten Hauptfläche des Substrats, einem an die Oberfläche grenzenden Kanalgebiet (16) des ersten Leitungstyps in der Epitaxieschicht, das mit dieser einen pn-Übergang (17) bildet, einem an die Oberfläche grenzenden Sourcegebiet (14) des zweiten Leitungstyps in dem genannten Kanalgebiet, einem an die Oberfläche grenzenden Draingebiet (20) des zweiten Leitungstyps in der Epitaxieschicht, das durch einen Abschnitt der genannten Epitaxieschicht von dem Kanalgebiet getrennt ist, einer Isolierschicht (22) auf der Epitaxieschicht, die mindestens den zwischen dem Sourcegebiet und dem Draingebiet liegenden Abschnitt (18) des Kanalgebiets bedeckt, einer Gate-Elektrode (24) auf der genannten Isolierschicht, über dem genannten Abschnitt des Kanalgebiets, die von der genannten Epitaxieschicht elektrisch isoliert ist, einem an die Oberfläche grenzenden Anodengebiet (21) des ersten Leitungstyps in der Epitaxieschicht neben dem Draingebiet und mit diesem elektrisch gekoppelt, einer mit dem Anodengebiet elektrisch verbundenen Elektrode (28), einer mit dem Sourcegebiet elektrisch verbundenen Source-Elektrode (26), einer das Substrat kontaktierenden Substratelektrode (29) und einer an der genannten ersten Hauptfläche des Substrats und unter dem Sourcegebiet und dem genannten Kanalgebiet liegenden ersten vergrabenen Schicht (32) des ersten Leitungstyps, dadurch gekennzeichnet, daß eine zweite vergrabene Schicht (34) des zweiten Leitungstyps an der genannten Hauptfläche des Substrats und unter dem genannten Anodengebiet und dem genannten Draingebiet liegt.

2. Halbleiteranordnung nach Anspruch 1, dadurch gekennzeichnet, daß das Anodengebiet (21) direkt neben und in direktem Kontakt mit dem Draingebiet (20) vorgesehen ist und daß die genannte mit dem Anodengebiet elektrisch verbundene Elektrode (28) sowohl das Draingebiet als auch das Anodengebiet unmittelbar kontaktiert.

## Revendications

1. Transistor à effet de champ à porte isolée latéral (3,4) muni d'un substrat semiconducteur (10) d'un premier type de conductivité présentant une surface principale (11), d'une couche superficielle épitaxiale (12) d'un deuxième type de conductivité opposé au premier type sur ladite surface principale dudit substrat, d'une région de canal confinant à la surface (16) dudit premier type de conductivité dans ladite couche épitaxiale et constituant une jonction pn (17) avec cette dernière, d'une région de source confinant à la surface (14) dudit deuxième type de conductivité dans ladite région de canal, d'une région de drain confinant à la surface (20) dudit deuxième type de conductivité située dans ladite couche épitaxiale et espacée de ladite région de canal par une partie de ladite couche épitaxiale, d'une couche isolante (22) située sur ladite couche épitaxiale et recouvrant au moins la partie (18) de ladite région de canal située entre ladite région de source et ladite région de drain, d'une électrode de porte (24) située sur ladite couche isolante et au-dessus de ladite partie de la région de canal et isolée électriquement de ladite couche épitaxiale, d'une région anodique (21) confinant à la surface du premier type de conductivité située dans ladite couche épitaxiale voisine de ladite région de drain et couplée électriquement à ladite région de drain, d'une électrode (28) connectée électriquement à ladite région anodique, une électrode de source (26) étant connectée électriquement à ladite région de source, une électrode de substrat étant présente pour contacter le substrat, et d'une première couche enterrée (32) dudit premier type de conductivité située à ladite surface principale dudit substrat et au-dessous de ladite région de source et de ladite région de canal, caractérisé en ce qu'une deuxième couche enterrée (34) dudit deuxième type de conductivité est située à ladite surface principale dudit substrat et au-dessous de ladite région anodique et de ladite région de drain.

2. Dispositif semiconducteur selon la revendication 1, caractérisé en ce que ladite région anodique (21) est appliquée de façon adjacente et en contact direct avec ladite région de drain (20) et en ce que ladite électrode (28) connectée électriquement à ladite région anodique est en contact direct avec ladite région de drain et ladite région anodique.
